# EUROPEAN PATENT APPLICATION

(11) **EP 4 734 688 A1**
(43) Date of publication of application: **29.04.2026**
(21) Application number: 25210859.2
(22) Date of filing: 23.10.2025
(51) Int. Cl.: H05K 7/20

(54) **CHILLED WATER SYSTEM WITH BYPASS VALVE**

(30) Priority: 25.10.2024 US 202463712024 P; 20.10.2025 US 202519363093
(71) Applicant: Vertiv Corporation, Westerville, OH 43082 (US)
(72) Inventor: BLASER, Colin Lewis, Westerville, 43082 (US); BREUER, Thomas Christopher, Westerville, 43082 (US); MILLER, Oliver McKenzey, Westerville, 43082 (US); RAVEN, Matthew Alan, Westerville, 43082 (US)
(74) Representative: Cousens, Nico

(57) **Abstract**

A cooling system for charging and discharging fluid is disclosed. The cooling system includes: a heat exchanger configured to fluidically communicate with a supply source; a supply line configured to supply to the heat exchanger from the supply source; a return line configured to return to the supply source from the heat exchanger; and a bypass valve configured to control communication between the supply line and the return line.

## Description

### CROSS-REFERENCE TO RELATED APPLICATIONS

The present application claims the benefit under 35 U.S.C. § 119(e) of U.S. Provisional Patent Application Serial Number 63/712,024 filed October 25, 2024, titled "CHILLED WATER SYSTEM WITH BYPASS VALVE".

### TECHNICAL FIELD

The present disclosure relates to cooling systems, more specifically, to systems and methods for controlling return water temperature.

### BACKGROUND

With the expansion of telecommunication and computer technology, increasing amounts of electronic equipment are required at various commercial and business facilities. To facilitate interconnection and access to such equipment, it is typically installed in a common room (e.g., data center). Furthermore, technological advancements are enabling more and more electronic equipment to be fitted into increasingly smaller spaces. These forces are combining to produce relatively dense electronic installations that generate increasing amounts of heat. In particular, data centers, which refer to spaces/rooms containing a collection of electronic equipment such as computer servers, have ever-rising heat density, requiring thermal systems to provide increased cooling density.

In order to prevent the overheat of electronic devices, data centers generally rely on large, oversized cooling infrastructures, including chilled water systems, chiller plants, and direct expansion cooling systems, to maintain their operating temperatures. Chilled water systems use water as a cooling medium circulated throughout the entire data center. The cooling systems using chilled water systems are utilized by industries with high computation loads or in large data centers for several benefits. Chilled water systems are efficient and can handle substantially higher heat loads than air conditioning systems, allowing them to manage variable heat demand throughout the day. Chilled water systems also provide a high number of redundancies, which makes the overall system reliable.

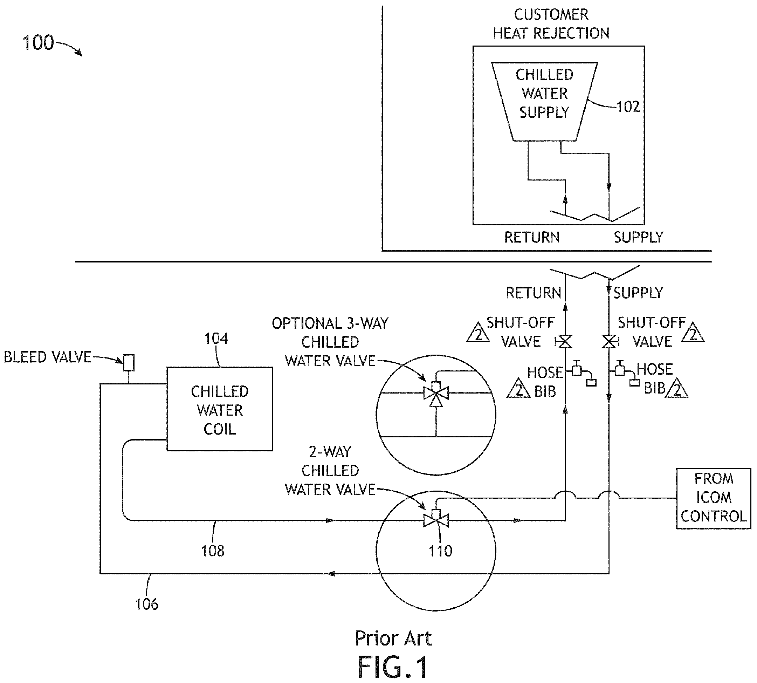

For instance, FIG. 1 shows an example of a typical chilled water-cooling system 100 for a data center according to a prior art. A chilled water supply 102 supplies chilled water to a chilled water coil 104 (e.g., heat exchanger) via a supply line 106. After colder fluid exchanges heat with warmer or hotter fluid at the heat exchanger 104, it returns to the chilled water supply 102 via a return supply line 108. The chilled water-cooling system 100 further includes several valves, such as a 2-way or 3-way valve 110 and shut-off valves installed on the supply and return lines 106 and 108, respectively. The 2-way or 3-way valve 110 allows the control of the amount of fluid to return to the chilled water supply 102. With such an existing or current configuration, return, which has heated up at the heat exchanger 104, merely returns to the supply 102, without being monitored or controlled. Accordingly, it may take longer for fluid to cool down once returned to the supply 102 from the heat exchanger 104, and further, fluid supplied from the supply 102 to the heat exchanger 104 may have a temperature higher than desired. The existing configuration requires additional steps to reduce the return water temperature when necessary, and there is no way to monitor the temperature returning to the water supply 102, thus incurring more costs and time.

Additionally, chilled water systems have a higher initial cost. The central equipment, distribution piping, and rack-level cooling systems are more expensive than air-conditioned cooling systems. These systems can also be susceptible to leaks, requiring professional installation and maintenance to avoid damaging valuable server hardware. In addition, if the data center does not run at its power consumption capacity due to load fluctuations, the efficiency of the traditional chiller plant drops significantly. Thus, it is not beneficial to make and install an entirely new cooling system to be able to monitor and adjust fluid temperature, particularly return temperature to the water supply.

In view of the foregoing, there is a need for improved systems and methods for coolant cooling systems that can efficiently monitor and control the temperature of the entire system without compromising the coolant supply and reducing maintenance costs.

### SUMMARY

It is accordingly an aspect of the present disclosure to overcome deficiencies in the prior art, such as indicated above. Another aspect is to allow for the customization of return water temperature independently of other constraints, thereby saving time and money.

It is often necessary to provide customized solutions, and customer constraints can lead to lengthy design processes and the development of many similar yet distinct products. In particular, return water temperature is a parameter that many customers want to specify, and can be difficult to achieve without modifying the existing coil.

The present disclosure can save time and money while designing new products for customers. The ability to automatically adjust return water temperatures eliminates the need to design custom coils or to make concessions to other constraints that the customer would want to adhere to. Similarly, it is possible to utilize the existing infrastructure and water temperatures even when changes in operating conditions occur in the future. The present disclosure further allows the existing chillers to operate within a more beneficial envelope at all times, saving money on energy costs, thus reducing the cost and amount of time associated with making custom coils for customization. Moreover, the present disclosure provides a quicker turnaround for our customers when there are specific constraints that must be adhered to, leading to a better experience and shorter lead times.

The packaging according to embodiments described herein, or elements thereof, accomplish one or more of these and other objectives.

Embodiments for a cooling system for charging and discharging fluid are disclosed. The cooling system includes: a heat exchanger configured to fluidically communicate with a supply source; a supply line configured to supply to the heat exchanger from the supply source; a return line configured to return to the supply source from the heat exchanger; and a bypass valve configured to control communication between the supply line and the return line.

In some embodiments, the system further includes one or more sensors for detecting sensing data; and a controller configured to communicate with the one or more sensors and to control the bypass valve. The sensing data may include a temperature of fluid measured on the return line. In some embodiments, when the sensing data is higher than a threshold, the controller controls the bypass valve to allow the communication between the supply line and the return line. When the sensing data is less than a threshold, the controller may control the bypass valve to block the communication between the supply line and the return line. When the sensing data is equal to a threshold, the controller may control the bypass valve to maintain a valve opening position.

In some embodiments, the system further includes: a 3-way valve disposed on the return line and communicating with the controller; and a flow control valve disposed on the return line and communicating with the controller. Each of the bypass valve and the flow control valve may be a 2-way valve. In some embodiments, the bypass valve is disposed between the supply source and the flow control valve, such that the bypass valve is configured to be controlled by fluid flowing from the heat exchanger to the supply source after passing through the flow control valve. In some embodiments, the system may further include shut-off valves respectively disposed on the supply line and the return line adjacent the supply source.

In some embodiments, a valve subsystem for a cooling system is disclosed. In some embodiments, the valve subsystem includes a bypass valve configured to control communication between a supply line of the cooling system and a return line of the cooling system, one or more sensors for detecting sensing data, and a controller configured to communicate with the one or more sensors and to control the bypass valve, wherein the sensing data includes a temperature of fluid measured on the return line.

Some embodiments include a method for controlling return temperature of the cooling system. The method may include: measuring, by one or more sensors, a temperature of fluid on the return line; comparing, by a controller, the measured temperature with a reference value; and controlling, by the controller, the bypass valve based on a comparing result.

In some embodiments, the step of comparing includes controlling, by the controller, the bypass valve to open, and step of determining whether the measured temperature is higher than a threshold includes determining whether the measured temperature is lower than or equal to the threshold.

In some embodiments, the step of controlling includes controlling, by the controller, the bypass valve to close, and the step of controlling includes controlling, by the controller, the bypass valve to maintain a current valve position.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims.
FIG. 1 shows an example of a typical chilled water-cooling system for a data center according to a prior art.
FIG. 2 shows a chilled water-cooling system according to an exemplary embodiment of the present disclosure.
FIG. 3 shows a process for controlling a chilled water-cooling system according to an exemplary embodiment of the present disclosure.
FIG. 4 is a block diagram of an example computing device that may be used to implement embodiments, according to embodiments of the present disclosure.

### DETAILED DESCRIPTION

The figures described above, and the written description of specific structures and functions below, are not presented to limit the scope of what Applicants have invented or the scope of the appended claims. Rather, the Figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's goal for the commercial embodiment. Such implementation-specific decisions may include and likely are not limited to, compliance with system-related, business-related, government-related, and other constraints, which may vary by specific implementation, location, and from time to time. While a developer's efforts might be complex and time-consuming in an absolute sense, such efforts would be, nevertheless, a routine undertaking for those of skill in this art having the benefit of this disclosure. It must be understood that the inventions disclosed and taught herein are susceptible to numerous and various modifications and alternative forms.

The use of a singular term, such as, but not limited to, "a," is not intended as limiting of the number of items. The use of relational terms, such as, but not limited to, "top," "bottom," "left," "right," "upper," "lower," "down," "up," "side," and the like are used in the written description for clarity in specific reference to the Figures and are not intended to limit the scope of the inventions or the appended claims. The terms "including" and "such as" are for illustrative purposes but not limited thereto. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume, and density, among others.

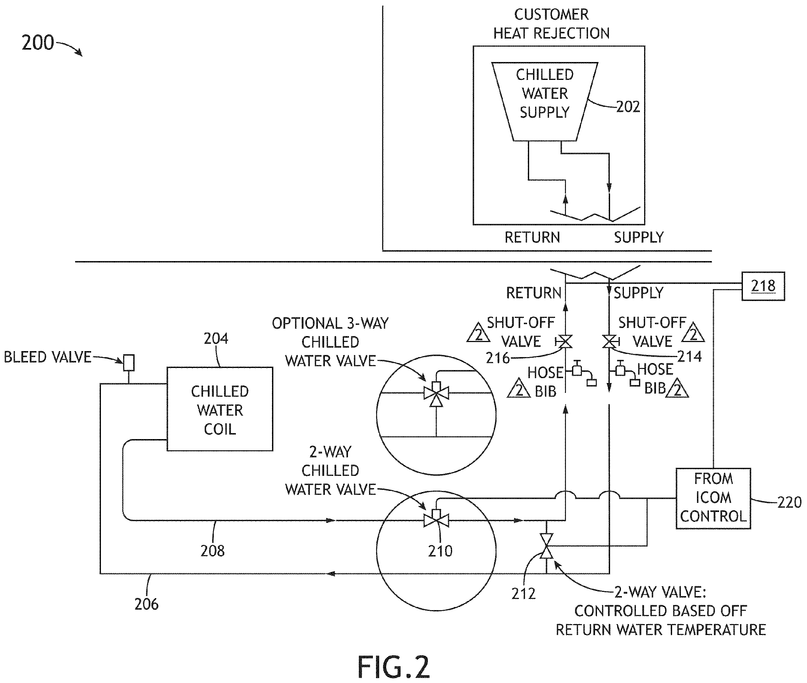

FIG. 2 shows a chilled water-cooling system 200 according to an exemplary embodiment of the present disclosure.

In some embodiments, the chilled water-cooling system 200 includes similar elements to the typical chilled water-cooling system 100 of FIG. 1. For instance, the system 200 may include a supply source 202 (or chilled water supply) that supplies chilled water to a coil (e.g., heat exchanger 204) via a supply line 206. After chilled or cold fluid exchanges heat with warmer fluid (which is heated by hot electronic devices) at the heat exchanger 204, it returns to the supply source 202 via a return supply line 208. The chilled water-cooling system 200 further includes several valves such as a 2-way or 3-way valve (or flow control valve) 210 and shut-off valves 214, 216 installed (e.g., disposed) on the supply and return lines 206, 208 (e.g., adjacent the supply source 202), respectively. The flow control valve 210 allows the control of the amount of fluid to return to the supply source 202.

In some embodiments, the chilled water-cooling system 200 further includes an additional 2-way valve or bypass valve 212. The bypass valve 212 may be installed (e.g., disposed) between the supply and return lines 206, 208 to control communication therebetween.

FIG. 2 shows, as one exemplary embodiment, that the bypass valve 212 can be installed (e.g., disposed) between the flow control valve 210 and the supply source 202 for controlling the flow of fluid passing from the heat exchanger 204 (e.g., the supply source 202 configured to fluidically communicate with the heat exchanger 204), after heat-exchanging with warmer fluid, to the supply source 202. The bypass valve 212 may be installed after fluid flow is controlled at the flow control valve 210.

The chilled water-cooling system 200 further includes one or more sensors 218 and a controller 220 communicating with the sensors 218. In some embodiments, the sensors 218 may include, but are not limited to, an energy sensor, an OEM power sensor, a power and energy meter, a thermal power sensor, an inductive sensor, an RF sensor, etc. The sensors 218 may further include other types of sensors, such as a temperature sensor, a humidity sensor, a pressure sensor, a displacement sensor, a voltage sensor, a current sensor, etc., communicating with the controller 220 to obtain various sensing data. In particular, the sensors 218 may be one or more temperature sensors for detecting fluid temperature within the fluid lines and in the supply source.

When sensing data obtained by the sensors 218 is higher than a threshold (e.g., a target temperature), the controller 220 controls the bypass valve 212 to block the communication between the supply line 206 and the return line 208. On the other hand, when the sensing data is less than the threshold, the controller 220 controls the bypass valve 212 to allow the communication between the supply line 206 and the return line 208. In addition, when the sensing data is equal to a threshold, the controller 220 controls the bypass valve 212 to maintain a valve opening position thereof. In some embodiments, the threshold can be set by an operator (e.g., customer) based on their target operating temperature or power usage.

In embodiments, a valve subsystem is disclosed that can add the functionality of causing supply water to mix with return water. For example, the valve subsystem may be added to or installed within a legacy cooling system that previously was not able to cause the supply water to mix with the return water. The valve subsystem may include one or more of the bypass valve 212, a sensor 218, the controller 220, and the flow control valve 210, and may include other componentry. Once installed, a legacy cooling system may then operate similarly to cooling system 200.

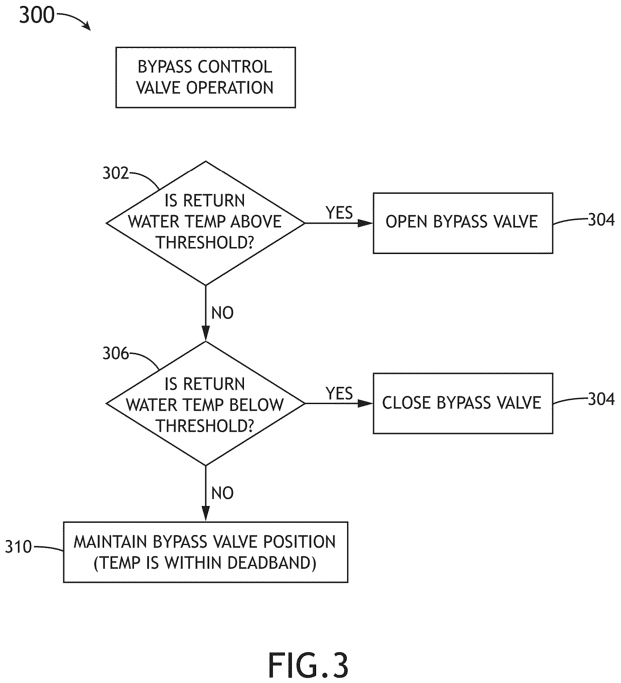

FIG. Figure 3 shows a process 300 for controlling a chilled water-cooling system according to an exemplary embodiment of the present disclosure.

The process 300 starts by measuring the temperature of fluid on the return line 208 by one or more sensors 218 and comparing it with a reference value or threshold by the controller 220. In step 302, the process 300 determines whether the temperature is above the threshold. If it is determined that the temperature is above the threshold (e.g., based on a comparison result), the controller 220 controls the bypass valve 212 to open in step 304. On the other hand, if the temperature is less than or equal to the threshold, the process 300 further determines whether the temperature is below the threshold in step 306. If it is determined that the temperature is below the threshold, the controller 220 controls the bypass valve 212 to close in step 308. If it is determined that the temperature is not below the threshold, the controller 220 maintains the bypass valve position in step 310.

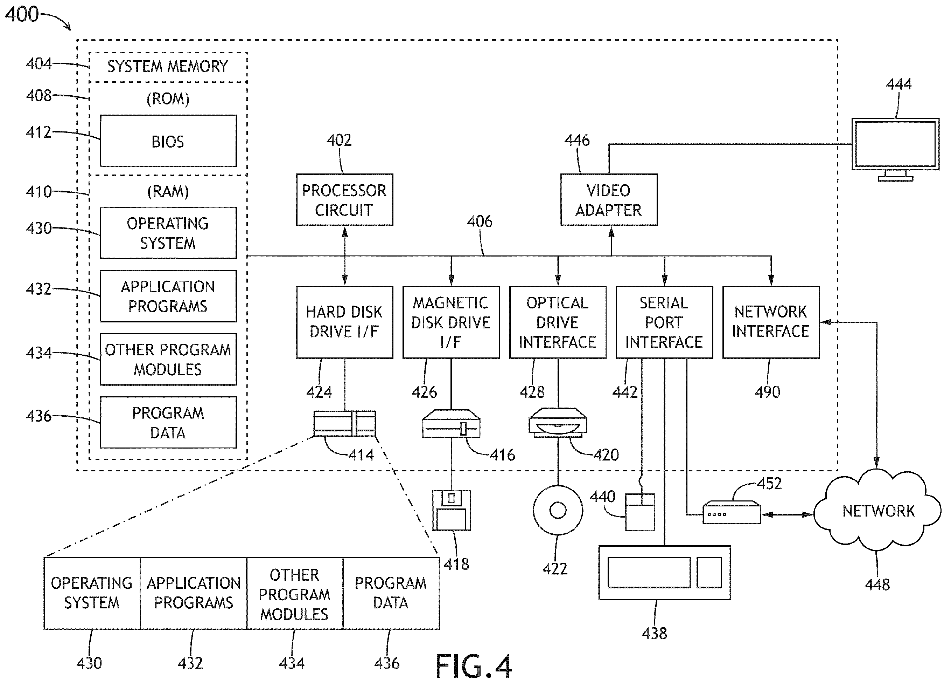

FIG. 4 depicts an example processor-based computer system 400 that may be used to implement various embodiments described herein. For example, processor-based computer system 400 may be used to implement any of the components of system 200 as described above in reference to FIG. 2. The description of the processor-based computer system 400 provided herein is provided for purposes of illustration and is not intended to be limiting. Embodiments may be implemented in further types of computer systems, as would be known to persons skilled in the relevant art(s).

As shown in FIG. 4, processor-based computer system 400 includes one or more processors, referred to as processor circuit 402, a system memory 404, and a bus 406 that couples various system components, including system memory 404, to processor circuit 402. Processor circuit 402 is an electrical and/or optical circuit implemented in one or more physical hardware electrical circuit device elements and/or integrated circuit devices (semiconductor material chips or dies) as a central processing unit (CPU), a microcontroller, a microprocessor, and/or other physical hardware processor circuit. Processor circuit 402 may execute program code stored in a computer-readable medium, such as program code of operating system 430, application programs 432, other programs 434, etc. Bus 406 represents one or more of any of several types of bus structures, including a memory bus or memory controller, a peripheral bus, an accelerated graphics port, and a processor or local bus using any of a variety of bus architectures. System memory 404 includes read-only memory (ROM) 408 and random-access memory (RAM) 410. A basic input/output system 412 (BIOS) is stored in ROM 408.

Processor-based computer system 400 also has one or more of the following drives: a hard disk drive 414 for reading from and writing to a hard disk, a magnetic disk drive 416 for reading from or writing to a removable magnetic disk 418, and an optical disk drive 420 for reading from or writing to a removable optical disk 422 such as a CD ROM, DVD ROM, or other optical media. Hard disk drive 414, magnetic disk drive 416, and optical disk drive 420 are connected to bus 406 by a hard disk drive interface 424, a magnetic disk drive interface 426, and an optical drive interface 428, respectively. The drives and their associated computer-readable media provide nonvolatile storage of computer-readable instructions, data structures, program modules, and other data for the computer. Although a hard disk, a removable magnetic disk, and a removable optical disk are described, other types of hardware-based computer-readable storage media can be used to store data, such as flash memory cards, digital video disks, RAMs, ROMs, and other hardware storage media.

A number of program modules may be stored on the hard disk, magnetic disk, optical disk, ROM, or RAM. These programs include operating system 430, one or more application programs 432, other programs 434, and program data 436. Application programs 432 or other programs 434 may include, for example, computer program logic (e.g., computer program code or instructions) for implementing the systems described above, including the embodiments described in reference to FIGS. 2 and 3.

A user may enter commands and information into processor-based computer system 400 through input devices such as keyboard 438 and pointing device 440. Other input devices (not shown) may include a microphone, joystick, game pad, satellite dish, scanner, a touch screen and/or touch pad, a voice recognition system to receive voice input, a gesture recognition system to receive gesture input or the like. These and other input devices are often connected to processor circuit 402 through a serial port interface 442 that is coupled to bus 406 but may be connected by other interfaces, such as a parallel port, game port, or a universal serial bus (USB).

A display screen 444 is also connected to bus 406 via an interface, such as a video adapter 446. Display screen 444 may be external to, or incorporated in processor-based computer system 400. Display screen 444 may display information, as well as being a user interface for receiving user commands and/or other information (e.g., by touch, finger gestures, virtual keyboard, etc.). In addition to display screen 444, processor-based computer system 400 may include other peripheral output devices (not shown) such as speakers and printers.

Processor-based computer system 400 is connected to a network 448 (e.g., the Internet) through an adaptor or network interface 450, a modem 452, or other means for establishing communications over the network. Modem 452, which may be internal or external, may be connected to bus 406 via serial port interface 442, as shown in FIG. 4, or may be connected to bus 406 using another interface type, including a parallel interface.

Embodiments are also directed to computer program products comprising computer code or instructions stored on any computer-readable medium. Such computer program products include hard disk drives, optical disk drives, memory device packages, portable memory sticks, memory cards, and other types of physical storage hardware.

As used herein, the terms "computer program medium," "computer-readable medium," and "computer-readable storage medium" are used to generally refer to physical hardware media such as the hard disk associated with hard disk drive 414, removable magnetic disk 418, removable optical disk 422, other physical hardware media such as RAMs, ROMs, flash memory cards, digital video disks, zip disks, MEMs, nanotechnology-based storage devices, and further types of physical/tangible hardware storage media (including system memory 404 of FIG. 4). Such computer-readable storage media are distinguished from and non-overlapping with communication media (do not include communication media). Communication media typically embodies computer-readable instructions, data structures, program modules, or other data in a modulated data signal such as a carrier wave. The term "modulated data signal" means a signal that has one or more of its characteristics set or changed in such a manner as to encode information in the signal. By way of example, and not limited, communication media includes wireless media such as acoustic, RF, infrared, and other wireless media, as well as wired media. Embodiments are also directed to such communication media.

As noted above, computer programs and modules (including application programs 432 and other programs 434) may be stored on the hard disk, magnetic disk, optical disk, ROM, RAM, or other hardware storage medium. Such computer programs may also be received via network interface 450, serial port interface 442, or any other interface type. Such computer programs, when executed or loaded by an application, enable processor-based computer system 400 to implement features of embodiments discussed herein. Accordingly, such computer programs represent controllers of processor-based computer system 400.

The present disclosure is directed to a bypass valve controlled by a feedback loop that will allow for variable return water temperatures to the chiller or cooling tower for chilled water applications. Today our return water temperature is dictated by the design of the coil and the airflow across that coil, as well as the flow rate of the water into the coil. With this disclosure, water supplied from the chiller can be diverted from the supply line back to the return line to reduce the temperature of water returning to the chiller. This is useful for two reasons. Firstly, chillers have an envelope within which they are most efficient, and this would help us to closer target that range. Second, if the customer has any secondary applications for which they need colder water in their facilities, this disclosure allows for them to produce colder water than would be possible without getting a custom coil designed. The operation of this disclosure is simple. One control valve that is currently used in Chilled Water (CW) units to meter water flow will still be included, however a bypass valve will also be added to divert cold water from the supply line directly to the return line, skipping the coil entirely to create a custom return water temperature to the chiller. This bypass valve will be controlled by the return water temperature and open and close accordingly.

In this application, including the definitions below, the term "module" or the term "controller" may be replaced with the term "circuit." The term "module" refers to or includes an Application Specific Integrated Circuit (ASIC); a digital, analog, or mixed analog/digital discrete circuit; a digital, analog, or mixed analog/digital integrated circuit; a combinational logic circuit; a field programmable gate array (FPGA); a processor circuit (shared, dedicated, or group) that executes code; a memory circuit (shared, dedicated, or group) that stores code executed by the processor circuit; other suitable hardware components that provide the described functionality; or a combination of some or all of the above, such as in a system-on-chip.

The module may include one or more interface circuits. In some examples, the interface circuits may include wired or wireless interfaces that are connected to a local area network (LAN), the Internet, a wide area network (WAN), or combinations thereof. The functionality of any given module of the present disclosure may be distributed among multiple modules that are connected via interface circuits. For example, multiple modules may allow load balancing. In a further example, a server (also known as remote, or cloud) module may accomplish some functionality on behalf of a client module.

The term code, as used above, may include software, firmware, and/or microcode, and may refer to programs, routines, functions, classes, data structures, and/or objects. The term shared processor circuit encompasses a single processor circuit that executes some or all code from multiple modules. The term group processor circuit encompasses a processor circuit that, in combination with additional processor circuits, executes some or all code from one or more modules. References to multiple processor circuits encompass multiple processor circuits on discrete dies, multiple processor circuits on a single die, multiple cores of a single processor circuit, multiple threads of a single processor circuit, or a combination of the above. The term shared memory circuit encompasses a single memory circuit that stores some or all code from multiple modules. The term group memory circuit encompasses a memory circuit that, in combination with additional memories, stores some or all code from one or more modules.

The term memory circuit is a subset of the term computer-readable medium. The term computer-readable medium, as used herein, does not encompass transitory electrical or electromagnetic signals propagating through a medium (such as on a carrier wave); the term computer-readable medium may therefore be considered tangible and non-transitory. Non-limiting examples of a non-transitory, tangible computer-readable medium are nonvolatile memory circuits (such as a flash memory circuit, an erasable programmable read-only memory circuit, or a mask read-only memory circuit), volatile memory circuits (such as a static random access memory circuit or a dynamic random access memory circuit), magnetic storage media (such as an analog or digital magnetic tape or a hard disk drive), and optical storage media (such as a CD, a DVD, or a Blu-ray Disc).

The apparatuses and methods described in this application may be partially or fully implemented by a special-purpose computer created by configuring a general-purpose computer to execute one or more particular functions embodied in computer programs. The functional blocks, flowchart components, and other elements described above serve as software specifications, which can be translated into computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with the hardware of the special-purpose computer, device drivers that interact with particular devices of the special-purpose computer, one or more operating systems, user applications, background services, background applications, etc.

In this application, including the definitions below, the term "module" or the term "controller" may be replaced with the term "circuit." The term "module" refers to or includes an Application Specific Integrated Circuit (ASIC); a digital, analog, or mixed analog/digital discrete circuit; a digital, analog, or mixed analog/digital integrated circuit; a combinational logic circuit; a field programmable gate array (FPGA); a processor circuit (shared, dedicated, or group) that executes code; a memory circuit (shared, dedicated, or group) that stores code executed by the processor circuit; other suitable hardware components that provide the described functionality; or a combination of some or all of the above, such as in a system-on-chip.

The module may include one or more interface circuits. In some examples, the interface circuits may include wired or wireless interfaces that are connected to a local area network (LAN), the Internet, a wide area network (WAN), or combinations thereof. The functionality of any given module of the present disclosure may be distributed among multiple modules that are connected via interface circuits. For example, multiple modules may allow load balancing. In a further example, a server (also known as remote, or cloud) module may accomplish some functionality on behalf of a client module.

The term code, as used above, may include software, firmware, and/or microcode, and may refer to programs, routines, functions, classes, data structures, and/or objects. The term shared processor circuit encompasses a single processor circuit that executes some or all code from multiple modules. The term group processor circuit encompasses a processor circuit that, in combination with additional processor circuits, executes some or all code from one or more modules. References to multiple processor circuits encompass multiple processor circuits on discrete dies, multiple processor circuits on a single die, multiple cores of a single processor circuit, multiple threads of a single processor circuit, or a combination of the above. The term shared memory circuit encompasses a single memory circuit that stores some or all code from multiple modules. The term group memory circuit encompasses a memory circuit that, in combination with additional memories, stores some or all code from one or more modules.

The term memory circuit is a subset of the term computer-readable medium. The term computer-readable medium, as used herein, does not encompass transitory electrical or electromagnetic signals propagating through a medium (such as on a carrier wave); the term computer-readable medium may therefore be considered tangible and non-transitory. Non-limiting examples of a non-transitory, tangible computer-readable medium are nonvolatile memory circuits (such as a flash memory circuit, an erasable programmable read-only memory circuit, or a mask read-only memory circuit), volatile memory circuits (such as a static random access memory circuit or a dynamic random access memory circuit), magnetic storage media (such as an analog or digital magnetic tape or a hard disk drive), and optical storage media (such as a CD, a DVD, or a Blu-ray Disc).

The apparatuses and methods described in this application may be partially or fully implemented by a special-purpose computer created by configuring a general-purpose computer to execute one or more particular functions embodied in computer programs. The functional blocks, flowchart components, and other elements described above serve as software specifications, which can be translated into computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with the hardware of the special-purpose computer, device drivers that interact with particular devices of the special-purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java^{®}, Fortran, Peri, Pascal, Curl, OCaml, Javascript^{®}, HTML5 (Hypertext Markup Language 5th revision), Ada, ASP (Active Server Pages), PHP (PHP: Hypertext Preprocessor), Scala, Eiffel, Smalltalk, Erlang, Ruby, Flash^{®}, Visual Basic^{®}, Lua, MATLAB, SIMULINK, and Python^{®}.

None of the elements recited in the claims are intended to be a means-plus-function element within the meaning of 35 U.S.C. § 112(f) unless an element is expressly recited using the phrase "means for," or in the case of a method claim using the phrases "operation for" or "step for."

Although the terms first, second, third, etc. may be used herein to describe various elements, pumps, condenser fans, compressors, circuits, components and/or modules, these items should not be limited by these terms. These terms may be only used to distinguish one item from another item. Terms such as "first," "second," and other numerical terms when used herein do not imply a sequence or order unless clearly indicated by the context. Thus, a first item discussed herein could be termed a second item without departing from the teachings of the example implementations.

Process flowcharts discussed herein illustrate the operation of possible implementations of systems, methods, and computer program products according to various embodiments of the present disclosure. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special-purpose hardware and computer instructions.

Also disclosed are the following numbered items:
1. A valve subsystem for a cooling system comprising:
   a bypass valve configured to control communication between a supply line of the cooling system and a return line of the cooling system;
   one or more sensors for detecting sensing data; and
   a controller configured to communicate with the one or more sensors and to control the bypass valve, wherein the sensing data includes a temperature of fluid measured on the return line.
2. The valve subsystem of item 1, wherein, when the sensing data is higher than a threshold, the controller controls the bypass valve to allow the communication between the supply line and the return line.
3. The valve subsystem of item 2, wherein the bypass valve is disposed between a supply source and a flow control valve, such that the bypass valve is configured to be controlled by fluid flowing from a heat exchanger of the cooling system to the supply source after passing through the flow control valve.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not intended to be exhaustive or to limit the embodiments to the precise forms disclosed. It will be apparent to one of ordinary skill in the art that many modifications and variations are possible in view of the above teachings.

## Claims

1. A cooling system comprising:
a heat exchanger configured to fluidically communicate with a supply source;
a supply line configured to supply to the heat exchanger from the supply source;
a return line configured to return to the supply source from the heat exchanger; and
a bypass valve configured to control communication between the supply line and the return line.

2. The system of claim 1, further comprising:
one or more sensors for detecting sensing data; and
a controller configured to communicate with the one or more sensors and to control the bypass valve.

3. The system of claim 2, wherein the sensing data includes a temperature of fluid measured on the return line.

4. The system of claim 2 or 3, wherein, when the sensing data is higher than a threshold, the controller controls the bypass valve to allow the communication between the supply line and the return line.

5. The system of any of claims 2 to 5, wherein, when the sensing data is less than a threshold, the controller controls the bypass valve to block the communication between the supply line and the return line.

6. The system of any of claims 2 to 6, wherein, when the sensing data is equal to a threshold, the controller controls the bypass valve to maintain a valve opening position.

7. The system of any of claims 2 to 7, further comprising:
a 3-way valve disposed on the return line and communicating with the controller.

8. The system of any of claims 2 to 8, further comprising:
a flow control valve disposed on the return line and communicating with the controller.

9. The system of claim 8, wherein each of the bypass valve and the flow control valve is a 2-way valve, and/or
wherein the bypass valve is disposed between the supply source and the flow control valve, such that the bypass valve is configured to be controlled by fluid flowing from the heat exchanger to the supply source after passing through the flow control valve.

10. The system of any preceding claim, further comprising shut-off valves respectively disposed on the supply line and the return line adjacent the supply source.

11. A method for controlling a return temperature of a cooling system, the method comprising steps of:
measuring, by one or more sensors, a temperature of fluid on a return line of the cooling system;
comparing, by a controller, a measured temperature with a reference value; and
controlling, by the controller, a bypass valve of the cooling system based on a comparison result.

12. The method of claim 11, wherein the step of comparing comprises:
determining whether the measured temperature is higher than a threshold.

13. The method of claim 11 or 12, wherein the step of controlling comprises:
upon determining that the measured temperature is higher than the threshold, controlling, by the controller, the bypass valve to open.

14. The method of any claims 11 to 13, the step of determining whether the measured temperature is higher than a threshold comprises:
upon determining that the measured temperature is not higher than the threshold, determining whether the measured temperature is lower than or equal to the threshold.

15. The method of claim 14, wherein the step of controlling comprises:
upon determining that the measured temperature is lower than the threshold, controlling, by the controller, the bypass valve to close, and/or,
wherein the step of controlling comprises:
upon determining that the measured temperature is equal to the threshold, controlling, by the controller, the bypass valve to maintain a current valve position.
